(19) Europäisches Patentamt
European Patent Office
Office européen des brevets

(11) **EP 2 750 201 A1**

(12) **EUROPEAN PATENT APPLICATION**
published in accordance with Art. 153(4) EPC

(43) Date of publication:
**02.07.2014 Bulletin 2014/27**

(51) Int Cl.:
***H01L 31/048*** (2014.01)

(21) Application number: **12848270.0**

(86) International application number:
**PCT/JP2012/078786**

(22) Date of filing: **07.11.2012**

(87) International publication number:
**WO 2013/069660 (16.05.2013 Gazette 2013/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.11.2011 JP 2011247099**

(71) Applicant: **Sanyo Electric Co., Ltd.**
**Moriguchi-city, Osaka 570-8677 (JP)**

(72) Inventor: **SAKUMA, Toshiyuki**
**Moriguchi City**
**Osaka 570-8677 (JP)**

(74) Representative: **Glawe, Delfs, Moll**
**Partnerschaft mbB von**
**Patent- und Rechtsanwälten**
**Postfach 26 01 62**
**80058 München (DE)**

(54) **SOLAR CELL MODULE**

(57) Provided is a solar cell module wherein a filling material layer does not easily turn yellow. A solar cell module (1) is provided with a solar cell (12), a first protection member (10), a second protection member (11), and a filling material layer (13). The solar cell (12) has a light receiving surface (12a) and a rear surface (12b). The first protection member (10) is disposed on the light receiving surface (12a) side of the solar cell (12). The first protection member (10) is configured of a glass plate.

The second protection member (11) is disposed on the rear surface (12b) side of the solar cell (12). The filling material layer (13) is provided between the first protection member (10) and the second protection member (11). The filling material layer (13) seals the solar cell. At least a part of the filling material layer (13) portion positioned further toward the rear surface (12b) side than the solar cell (12) contains an acid additive.

Fig.1

EP 2 750 201 A1

## Description

TECHNICAL FIELD

The invention relates to a solar cell module.

BACKGROUND ART

In recent years, solar cell modules as described in Patent Document 1 have been drawing attention as an environmentally-friendly energy source.
Such a solar cell module includes solar cells configured to generate electric power by receiving light. The solar cells are easily deteriorated by contact with moisture and the like. For this reason, the solar cells need to be isolated from the ambient air. To this end, the solar cells are usually sealed with a filler layer provided between a pair of protection members. At least one of the pair of protection members is made of glass.

PRIOR ART DOCUMENT

PATENT DOCUMENT

Patent Document 1: Japanese Patent Application Publication No. 2005-129926

SUMMARY OF THE INVENTION

PROBLEM TO BE SOLVED BY THE INVENTION

However, in such a solar cell module, an alkaline component such as Na coming out of a glass plate forming the protection member may sometimes alkalize the filler layer and yellow the filler layer.
A main object of the invention is to provide a solar cell module in which a filler layer does not easily become yellowed.

MEANS FOR SOLVING THE PROBLEM

A solar cell module of the invention includes a solar cell, a first protection member, a second protection member, and a filler layer. The solar cell has a light-receiving surface and a back surface. The first protection member is disposed at a light-receiving surface side of the solar cell. The first protection member is made of a glass plate. The second protection member is disposed at a back surface side of the solar cell. The filler layer is provided between the first protection member and the second protection member. The filler layer seals the solar cell. At least part of a portion of the filler layer situated at the back surface side of the solar cell contains an acidic additive.

EFFECT OF THE INVENTION

According to the invention, a solar cell module in which a filler layer does not easily become yellowed can be provided.

BRIEF DESCRIPTION OF THE DRAWING

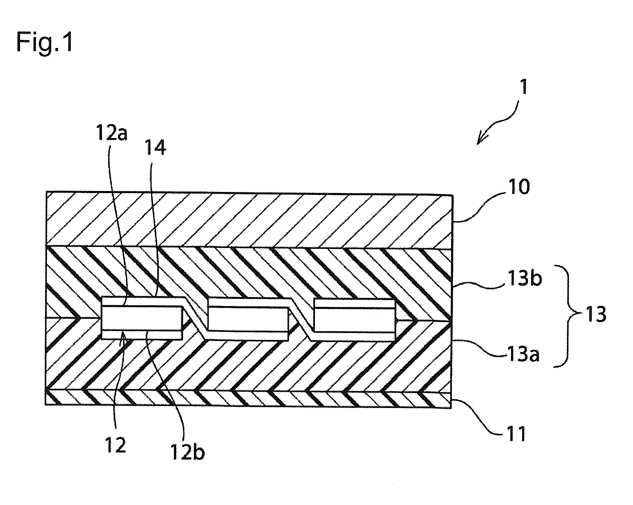

[Fig. 1] Fig. 1 is a schematic cross-sectional view of a solar cell module according to an embodiment of the invention.

MODES FOR CARRYING OUT THE INVENTION

Hereinbelow, an example of preferred embodiments of the invention is described. It is to be noted that the following embodiments are mere illustration of an example. The invention is not at all limited to the following embodiments.
Moreover, the drawing to be referred to in the embodiments is a schematic illustration, and the dimensional proportions and the like of objects depicted in the drawing may be different from the actual dimensional proportions and the like of the objects. The specific dimensional proportions and the like of the objects should be determined based on the following description.
As illustrated in Fig. 1, solar cell module 1 includes solar cells 12. Each solar cell 12 has light-receiving surface 12a and back surface 12b. The type of solar cell 12 is not particularly limited. For example, solar cell 12 may be a crystalline silicon solar cell, a thin film solar cell, or the like. Solar cell 12 may have a P-side electrode disposed at one main surface and an N-side electrode disposed at the other main surface. Alternatively, solar cell 12 may have both a P-side electrode and an N-side electrode at one main surface. Here, "light-receiving surface" refers to one of the two main surfaces of the solar cell which mainly receives light. Solar cell 12 may be configured to generate electric power only when receiving light at light-receiving surface 12a, or configured to generate electric power not only when receiving light at light-receiving surface 12a but also when receiving light at back surface 12b. Solar cells 12 are electrically connected to each other by wiring materials 14.

First protection member 10 is disposed at the light-receiving surface 12a side of each solar cell 12. First protection member 10 can be made of a glass plate.

Second protection member 11 is disposed at the back surface 12b side of each solar cell 12. Second protection member 11 faces first protection member 10. Second protection member 11 can be made of a resin, for example. Second protection member 11 preferably contains a polyolefin resin and more preferably contains at least one of polyethylene resin and polypropylene resin. Second protection member 11 does preferably not include any metal layer made of aluminum or the like or any inorganic layer made of silica or the like.

Filler layer 13 is provided between first protection member 10 and second protection member 11. Filler layer 13 seals solar cells 12.

In this embodiment, filler layer 13 includes first filler layer 13a and second filler layer 13b. First filler layer 13a is provided between each solar cell 12 and second protection member 11. Second filler layer 13b is provided between each solar cell 12 and first protection member 10.

Filler layer 13 can be made of a resin, for example. Filler layer 13 may be made solely of the resin or may contain a residue such for example as a crosslinking agent in addition to the resin.

Resin which filler layer 13 is made of is not particularly limited. However, filler layer 13 is preferably made, for example, of ethylene-vinyl acetate copolymer (EVA), a polyolefin resin such as polyethylene, or the like.

At least part of a portion of filler layer 13 situated at the light-receiving surface 12a side of solar cell 12 preferably contains a non-crosslinked resin. Specifically, second filler layer 13b preferably contains the non-crosslinked resin. In the invention, the non-crosslinked resin refers to a resin with a gel fraction of 50% or below. First filler layer 13a preferably contains a crosslinked resin. In the invention, the crosslinked resin refers to a resin with a gel fraction above 50%.

Note that in the invention, "gel fraction" is measured using the following measurement method. 1 g of the resin to be measured is prepared. This resin is immersed in 100 ml of xylene for 24 hours at 120°C. Then, the residue in the xylene is taken out and dried for 16 hours at 80°C. Then, the mass of the dried residue is measured. From the results thus obtained, the gel fraction (%) is calculated based on an equation (1) given below.

(Gel Fraction (%)) = (Mass of Residue (g)) / (Mass of Resin before Immersion (g)) ……… (1)

At least part of a portion of filler layer 13 situated at the back surface 12b side of solar cell 12 contains an acidic additive. Specifically, first filler layer 13a contains the acidic additive. The acidic additive may be an additive which itself is an acidic component, or an additive that produces an acidic component through decomposition, or the like. Of the above acidic additives, examples of the acidic additive which itself is an acidic component include an N-OR type hindered amine light stabilizer, a pigment dispersed sol acidized using an ion-exchange resin, and the like. Of the above acidic additives, examples of the acidic additive which produces an acidic component through decomposition or the like include a phosphate-ester containing hindered phenol antioxidant, an ester-bond containing crosslinking agent, and the like. The at least part of the portion of filler layer 13 situated at the back surface 12b side of solar cell 12 may contain only one of the acidic additives or two or more of the acidic additives. Not only the at least part of but also other parts of the portion of filler layer 13 situated at the back surface 12b side of solar cell 12 may contain the above-described acidic additive.

As mentioned earlier, in a solar cell module, an alkaline component such as Na coming out of a glass plate forming a protection member may sometimes alkalize a filler layer and yellow the filler layer. This yellowing can be alleviated by exposing the filler layer to ultraviolet light. However, the filler layer situated at the back surface side of each solar cell does not easily get exposed to ultraviolet light. Thus, it is difficult to solve the yellowing particularly for the filler layer situated at the back surface side.

In view of this, in solar cell module 1, at least part of the portion of filler layer 13 situated at the back surface 12b side of solar cell 12 contains the acidic additive. Thus, even when an alkaline component coming out of the glass plate reaches the at least part of the portion of filler layer 13 situated at the back surface 12b side of solar cell 12, this part does not easily become alkalized. Accordingly, in solar cell module 1, filler layer 13 does not easily yellowed by the alkaline component.

In solar cell module 1, filler layer 13 is yellowed by the alkaline component even less easily in the case where not only the at least part of but also other parts of the portion of filler layer 13 situated at the back surface 12b side of solar cell 12 contain the acidic additive.

In the case where at least part of the portion of filler layer 13 situated at the light-receiving surface 12a side of solar cell 12 contains a non-crosslinked resin, this part is highly flexible when at high temperature, and the alkaline component can easily reach it. Thus, in this case, this embodiment, which is capable of suppressing the yellowing is effective.

In the case where second protection member 11 contains a polyolefin resin, the acidic component of the acidic additive does not easily become dispersed to second protection member 11 because the polarity of the polyolefin resin is low. Thus, it is possible to suppress decrease in the density of the acidic component of the acidic additive in the at least part of the portion of filler layer 13 situated at the light-receiving surface 12a side of solar cell 12.

In the case where second protection member 11 includes no metal layer, oxygen easily enters filler layer 13 from the outside of solar cell module 1 through second protection member 11. Thus, in filler layer 13, the acidic additive is decomposed, providing an acidic atmosphere inside the filler. Accordingly, the yellowing can be alleviated more easily.

EXPLANATION OF THE REFERENCE NUMERALS

1       solar cell module
10      first protection member
11      second protection member
12      solar cell
12a     light-receiving surface of solar cell
12b     back surface of solar cell
13      filler layer
13a     first filler layer
13b     second filler layer
14      wiring material

**Claims**

1.  A solar cell module, comprising:

    a solar cell with a light-receiving surface and a back surface;
    a first protection member disposed at a light-receiving surface side of the solar cell and made of a glass plate;
    a second protection member disposed at a back surface side of the solar cell; and
    a filler layer provided between the first protection member and the second protection member and sealing the solar cell, wherein
    at least part of a portion of the filler layer situated at the back surface side of the solar cell contains an acidic additive.

2.  The solar cell module according to claim 1, wherein the acidic additive is at least one kind selected from a group including a light stabilizer, an antioxidant, a pigment dispersed sol, and a crosslinking agent.

3.  The solar cell module according to claim 1 or 2, wherein at least part of a portion of the filler layer situated at the light-receiving surface side of the solar cell contains a non-crosslinked resin.

4.  The solar cell module according to any one of claims 1 to 3, wherein the second protection member contains a polyolefin resin.

5.  The solar cell module according to any one of claims 1 to 4, wherein the second protection member includes no metal layer.

Fig.1

<div align="center">

**INTERNATIONAL SEARCH REPORT**

</div>

| International application No. |
|---|
| PCT/JP2012/078786 |

**A. CLASSIFICATION OF SUBJECT MATTER**
*H01L31/048*(2006.01)i

According to International Patent Classification (IPC) or to both national classification and IPC

**B. FIELDS SEARCHED**

Minimum documentation searched (classification system followed by classification symbols)
H01L31/04-31/078, H01L31/0203, C08K3/00-13/08, C09J11/00-11/08, C09J7/00,
C09K3/10

Documentation searched other than minimum documentation to the extent that such documents are included in the fields searched
Jitsuyo Shinan Koho        1922–1996   Jitsuyo Shinan Toroku Koho    1996–2012
Kokai Jitsuyo Shinan Koho   1971–2012   Toroku Jitsuyo Shinan Koho    1994–2012

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | WO 2010/106000 A1  (KURARAY EUROPE GMBH),<br>23 September 2010 (23.09.2010),<br>paragraphs [0064] to [0077]; claim 5<br>& EP 2408619 A1          & DE 102009001629 A1<br>& MX 2011009662 A         & CN 102355992 A<br>& JP 2012-521083 A | 1-2,4-5<br>3 |
| X<br>Y | WO 2011/009568 A1  (RENOLIT BELGIUM N.V.),<br>27 January 2011 (27.01.2011),<br>paragraphs [00151], [00165]<br>& EP 2277693 A1          & EP 2461973 A1<br>& EP 2277694 A1          & CN 102470633 A<br>& TW 201127628 A         & US 2012/0111407 A1 | 1-2,4-5<br>3 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>    22 November, 2012 (22.11.12) | Date of mailing of the international search report<br>    04 December, 2012 (04.12.12) |
|---|---|
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/078786

C (Continuation).  DOCUMENTS CONSIDERED TO BE RELEVANT

| Category* | Citation of document, with indication, where appropriate, of the relevant passages | Relevant to claim No. |
|---|---|---|
| X<br>Y | JP 2005-054019 A  (Du Pont-Mitsui Polychemicals Co., Ltd.),<br>03 March 2005 (03.03.2005),<br>paragraphs [0001], [0036], [0044]<br>(Family: none) | 1-2,4-5<br>3 |
| X<br>Y | JP 2008-159856 A  (Bridgestone Corp.),<br>10 July 2008 (10.07.2008),<br>paragraphs [0003], [0007], [0056] to [0077]<br>(Family: none) | 1-2,4-5<br>3 |
| Y | JP 10-341030 A  (Canon Inc.),<br>22 December 1998 (22.12.1998),<br>entire text; all drawings<br>& US 6204443 B1 | 3 |
| A | JP 2011-511448 A  (Renolit Belgium N.V.),<br>07 April 2011 (07.04.2011),<br>paragraph [0097]<br>& US 2011/0041891 A1    & EP 2250679 A2<br>& WO 2009/095274 A2    & AU 2009210217 A1<br>& CA 2712668 A1        & CN 101933164 A | 1-5 |
| A | JP 2004-083850 A  (Teijin Chemicals Ltd.),<br>18 March 2004 (18.03.2004),<br>paragraphs [0080], [0089], [0217]<br>& US 2004/0152806 A1    & EP 1553140 A1<br>& WO 2003/095557 A1    & DE 60314653 T2<br>& CA 2452455 A        & AT 365771 T<br>& CN 1533414 A        & ES 2288215 T<br>& AU 2003231576 A     & AU 2003231576 A1 | 1-5 |
| A | JP 2004-531893 A  (RWE Schott Solar Inc.),<br>14 October 2004 (14.10.2004),<br>paragraph [0007]<br>& US 2003/0000568 A1    & EP 1396034 A1<br>& WO 2002/103809 A1 | 1-5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005129926 A